# EUROPEAN PATENT SPECIFICATION

(11) **EP 1 071 119 B1**
(45) Date of publication and mention of the grant of the patent: **10.11.2004**
(21) Application number: 99114492.4
(22) Date of filing: 23.07.1999
(51) Int. Cl.: H01L 21/00

(54) **Handling apparatus for front opening unified pod**
Handhabungsvorrichtung für vereinheitlichten Behälter mit Vorderöffnung
Dispositif de manipulation pour conteneur unifie ayant une ouverture par l'avant

(43) Date of publication of application: 24.01.2001
(73) Proprietor: MOTOROLA, INC., Schaumburg, IL 60196 (US); Infineon Technologies AG, 81669 München (DE); Infineon Technologies SC300 GmbH & Co. KG, 01099 Dresden (DE)
(72) Inventor: Haris, Clinton, 01099 Dresden (DE); Hantzschmann, Karli, 01099 Dresden (DE); Frisa, Larry Edward, 01099 Dresden (DE)
(74) Representative: Wharmby, Martin Angus

(56) References cited:
- DE-A- 4 037 204
- US-A- 5 658 028
- US-A- 5 823 593
- PATENT ABSTRACTS OF JAPAN vol. 018, no. 414 (E-1587), 3 August 1994 (1994-08-03) -& JP 06 124993 A (SONY CORP), 6 May 1994 (1994-05-06)

## Description

### Field of the Invention

The present invention relates to a handling apparatus for the manual handling of a handless Front Opening Unified Pod (FOUP) containing wafers and in particular the manual transport of an FOUP in a clean room.

### Background of the Invention

The Front Opening Unified Pod (FOUP) is a clean, reliable and cost-effective wafer carrier. In the wafer production it is generally used for storing and transport one or several wafers between subsequent manufacturing stages. The demands as to reliability and versatility of the pods are high in particular with 300 mm wafers. The pod must offer sufficient seal performance, process control, and washability. Electrostatic discharge events in the pods are to be suppressed. Outgassing must be ultra-low.

The front opening unified pods which meet the above requirements and which are currently used in factories comprise a bottom wall, a top wall, and three side walls. One side of the box remains open so as to provide access to its interior, where up to 25 wafers of 300 mm diameter can be stored. Generally the pods are handled by robots. This ensures a high reliability of transport of the wafers. Further the use of remotely controllable robots is a precondition for a highly automated fabrication. To this end all presently used front opening unified pods are provided with a flange on the upper surface of the top wall to which a robot arm can be attached.

US 5 658 028 discloses a handling apparatus for a wafer carrier, as used in the prior art.

Yet, transport of the pods must not be limited to robots only. Even in 'lights out', fully automated factories users must be able to manually load/unload the FOUPs as a manual backup solution in the factory.

There are at least two ways for the operator to manually load/unload the FOUPs. If the operator wants to pick up an FOUP by hand sufficient space must be provided between the FOUPs to let the operator get hold of one of them. Such a pitch between the FOUPs is also necessary if the operator picks up an FOUP by forklift which is brought underneath the FOUP and then carries the FOUP: since the centre of gravity of the FOUP is above the forklift it must be averted to impart the FOUP a horizontal momentum, e.g. by friction between neighbouring FOUPs. Otherwise the FOUP would tend to topple from the forklift.

Thus, the FOUPs must not be packed side by side, but space is to be provided between neighbouring FOUPs. In other words, current FOUP handle designs force material handling system designers to build an additional pitch into their systems to permit operators to manually load/unload single FOUPs of such systems. The dimension of the pitch is normally about 30 mm width. The pitch means a detriment to the package density of the FOUPs on the whole.

A mechanism for handling an FOUP is needed that does not necessarily induce the requirement of a pitch.

Accordingly, it is a purpose of the present invention to provide a handling apparatus for manipulating a front opening unified pod manually and independently of neighbouring pods and devices.

### Summary of the Invention

The above problems are solved and the above purposes are realised by a handling apparatus for manipulating a front opening unified pod as claimed in claim 1. The dependent claims are directed to preferred embodiments of the invention.

The general idea underlying the present invention is a mechanism with grippers that clamp onto a required feature of the FOUP, namely the top robotic flange. The handling apparatus according to the invention with two grippers can be attached to the robotic flange from the front, from any of the two sides and from the rear of the FOUP, respectively. Further, the handling apparatus may be detachable from or permanently fixed to the FOUP so that it is usable for loading/unloading/moving FOUPs in the factory as a manual backup solution.

The front opening unified pod for which the handling apparatus according to the present invention is devised comprises of three side walls, a bottom wall, and a top wall, the top wall being provided with a robotic flange to which a robot arm is attachable. The handling apparatus according to the present invention is characterised by a bar with two handles and two grippers for being clamped onto said robotic flange. The bar extends substantially along a first axis, whereas the handles and the grippers extend substantially perpendicularly to said first axis. When applying the handling apparatus the operator first attaches the two grippers to the robotic flange of the front opening unified pod and is then able to manipulate the pod by the handles, i.e. is able to load/unload/move the FOUP from and to the FOUP storage system and/or any other docking station.

In a preferred embodiment of the handling apparatus the length of the grippers and/or the length of the handles is such that the grippers can be attached to the FOUP from the side, from the front or from the rear of the FOUP, respectively.

In order to improve the flexibility of the handling apparatus each handle and/or each gripper is further lockably coupled to the bar. Each handle and/or each gripper swivels thus around the bar, and the operator can attach the handling apparatus to the FOUP even if the FOUP is placed directly under an obstacle or in a narrow recess where direct access is hampered. In this case the operator attaches the gripper at the robotic flange with the handle in a first position, moves the FOUP out of the recess, and, for a more convenient transport, may afterwards bring the handles into a second position which is more appropriate for carrying the FOUP. The first and second positions of the handles in respect to the bar may be predetermined by a spring and a latch with this embodiment. In an alternative embodiment each handle may be lockably coupled to the bar so as to render each handle swivelling around a second axis. This second axis is preferably perpendicular to the plane of said handle and said bar. Hence, when the handling apparatus is attached to a front opening unified pod the handles may be positioned in such a way that they require the least space and are closest to the surface of the FOUP. In particular the handles may fold down flush with the side walls of the FOUP.

For a sufficient stiffness of the handling apparatus for carrying also rather heavy loads the handle and/or the gripper is made of rubber, hard plastic or metal. In any case, the chosen material has to be clean room compatible, as aluminium for example. However, for a better and more convenient grip and for prevention of damaging the FOUP the handle and/or the gripper of the handling apparatus is covered by a smooth layer such as rubber, soft plastic or cloth.

An advantage of the handling apparatus according to the invention is that it can be used as a standard handling system for FOUPs from different manufacturers because all manufacturers must use the same standardised top robotic flange.

### Brief Description of the Drawings

Fig. 1 is a view in top plan of the handling apparatus according to a first embodiment of the invention being attached to an FOUP from the rear.
Fig. 2 is a view in top plan of the handling apparatus according to a first embodiment of the invention being attached to an FOUP from one side.
Fig. 3 is a perspective view of a handling apparatus according to the invention just before being attached to an FOUP from the rear.
Fig. 4A and 4B are perspective views of a handling apparatus according to the first embodiment of the invention with two different positions of the handles, respectively.
Fig. 5 is a view in top plan of the handling apparatus according to a second embodiment of the invention being attached to an FOUP from the rear.

### Detailed Description of the Preferred Embodiment

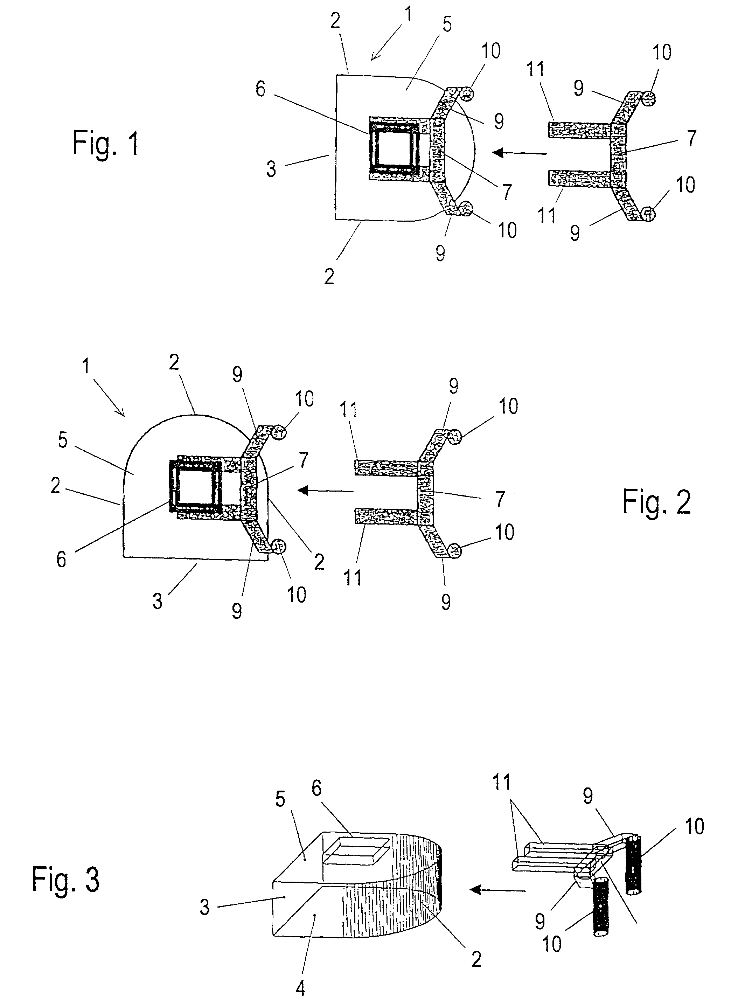

Fig. 1 is a view in top plan of the handling apparatus according to a first embodiment of the invention. In the situation of Fig. 1 the handling apparatus is being attached to a front opening unified pod (FOUP) 1 from the rear. First, the handling apparatus is apart from the FOUP 1 (right part of Fig. 1), then the handling apparatus is clamped to the FOUP 1 (left part of Fig. 1). The direction in which the handling apparatus is attached to the FOUP 1 is indicated by an arrow from right to left between the two parts of Fig. 1. The rear of the FOUP 1 is the curved side, whereas the flat side opposite the FOUP rear end comprises an opening (not shown) providing access to the wafers inside the FOUP. A normal size FOUP can be packed with up to 25 wafers of 300 mm diameter. A schematic view of an FOUP 1 to which the present invention is applicable is shown in Fig. 3.

Fig. 3 is a perspective view of an FOUP 1 and a handling apparatus according to the invention just before the handling apparatus is attached to the FOUP from the rear. The front opening unified pod 1 comprises a side wall 2 which includes substantially three portions, two of which are flat, whereas the third is curved and constitutes the rear of the FOUP. An opening 3 is provided in the box opposite its rear side. In the rest of this specification each of the two flat portions as well as the curved portion (i.e. rear) of the side wall will be referred to as a proper side wall 2. The FOUP 1 is completed by a bottom wall 4 and a top wall 5. Thus, the FOUP is substantially a box with one open side. The top wall 5 is provided with a robotic flange 6 to which a robot arm (not shown) is attachable. The robotic flange 6 mainly serves as a fixation for the transport of the FOUP 1 by a robot. Yet, the flange 6 may also provide access to the interior of the FOUP for sensors, gas supply/exhaust etc..

Referring back to Fig. 1 the handling apparatus according to the present invention for manipulating such front opening unified pod 1 comprises a bar 7 as principal element from which a pair of grippers 11 and a pair of handles 9 extend, respectively. The bar 7 may be a simple rod of a stiff plastic material or a metal rail. The grippers 11 are preferably flat parallel rails with an appropriate distance from each other so as to encompass the robotic flange 6 of the FOUP 1. In use the two grippers 11 are clamped onto said robotic flange 6. After use the FOUP is released from the handling apparatus by slightly spreading and withdrawing the grippers 11.

Both, the two handles 9 as well as the two grippers 11 extend substantially in a direction perpendicular to said bar 7. However, in order to leave enough space for the hands of the operator between the handles 9 and the FOUP 1 the handles 9 may be inclined so as to extend perpendicularly and in addition laterally from the bar 7. The embodiment with such inclined handles 9 is shown in the Figures and will be discussed in the rest of the specification without limiting the invention to inclined handles.

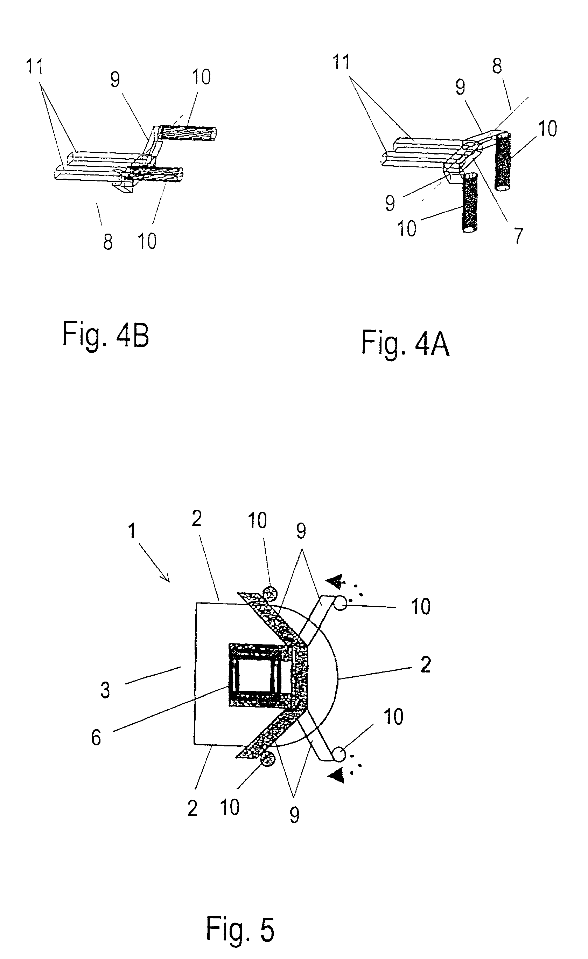

For a more convenient handling the handles 9 are each provided with a hand rod 10, which extends in a perpendicular direction to the handle 9. The hand rods 10 are shown as circles in Fig. 1, 2 and 5 and are shown in perspective view in Fig. 3, 4A, and 4B.

Fig. 2 is a view in top plan of the handling apparatus that corresponds to that of Fig. 1. However, in Fig. 2 the handling apparatus is attached to the FOUP 1 from the side instead from the rear. As in Fig. 1 first the handling apparatus is apart from the FOUP 1 (right part of Fig. 2) then the handling apparatus is clamped to the FOUP 1 (left part of Fig. 2). The direction in which the handling apparatus is attached to the FOUP 1 is indicated by an arrow from right to left. In order to meet the demand of being attachable from the rear (Fig. 1) as well as from one side (Fig. 2) of the FOUP the length of the grippers 11 and the length of the handles 9 must be determined appropriately. In both cases a safe contact must be ensured between the grippers 11 and the flange 6, and enough space must be left for the operator's hands.

It should be noted that, although not shown in the figures, the handling apparatus is preferably attachable also from the front of the FOUP. Since, however, the robotic flange on the FOUP is located in the centre of the top wall with substantially the same distance to each of the side walls, it emerges almost automatically that the handling apparatus is attachable from all four sides.

In order to allow for maximum flexibility with material handling systems the handling apparatus according to the invention is preferably designed such that the handles can be moved to the front, back, sides or top of the FOUP. Two embodiments with movable handles are shown in Fig. 4A, 4B and 5, respectively.

Fig. 4A and 4B are perspective views of a handling apparatus according to the invention with the bar as a pivot around which each handle and/or each gripper swivels. Preferably the normal position is a "flat" position, that is handles 9 and grippers 11 are substantially parallel to each other so that the handling apparatus requires the least space. This position is shown in Fig. 4A. The handling apparatus may be kept in the "flat" position by means of a coil spring (not shown) which is curled up around and fixed with one end to the bar 7. The other end of the coil spring is fixed to the handle 9. The grippers 11 are rigidly fixed to the bar 7. In use, with the FOUP picked up between the grippers 11, the handles 9 of the handling apparatus are swivelled down so that the operator can conveniently carry the FOUP in front of him. This position of the handling apparatus is shown in Fig. 4B. The difference between both the positions of Fig. 4A and of Fig. 4B is that the handles 9 have swivelled around a first axis 8. This first axis 8 essentially coincides with the axis of the bar 7.

However, it will be understood by those skilled in the art that instead of the grippers 11 being rigidly fixed at the bar 7 and the handles 9 swivelling freely around the bar 7 this can be arranged vice versa. In that case a coil spring is fixed with one of its ends to the bar 7 and with the other of its ends to the grippers 11. Further, in principle it is also possible to let both grippers 11 and handles 9 swivel around the bar 7. This requires two pairs of coil springs, one for the grippers 11 and one for the handles 9. The arrangement with two pairs of springs allows of weaker coil springs.

Preferably small latches (not shown) are provided so that none of the handles 9 and/or none of the grippers 11 swivels around the bar 7 beyond a range between two fixed positions. The positions can lay e.g. 90° apart with a "flat" position being the normal position, and the bent position being the position with a load. By this it is ensured that the maximum load to be carried by the handling apparatus is independent from the spring force(s) since the weight of the FOUP is carried by the latch. Moreover, the position in which the maximum load is hold by the handling apparatus can be chosen so that the handles 9 fold down flush with the sides 2 of the box or encompass a predetermined angle with the sides 2 of the FOUP. Thus the pitch impact is minimised. Further, the spring can be designed such that even in the normal position there is a certain tension of the spring(s) pushing the handles and/or grippers into the normal "flat" position.

It will be understood by those skilled in the art that further means can be provided to make handles 9 and/or grippers 11 lockable on the bar 7 in any position within a predetermined range, independently of any spring force. By such means the position of the handles can be optimised to the actual situation, e.g. to the wafer load of the FOUP 1, and to the personal preferences of the operator.

Besides the above embodiment with the handles 9 and/or grippers 11 swivelling around the first axis 8 the handles 9 can also rotate around a second axis (not shown) that is perpendicular to the bar 7, to the grippers 11, and to the handle 9. The second axis is thus perpendicular to the plane of said handle 9 and said bar 7. This embodiment is shown in Fig. 5. Fig. 5 is a view in top plan of the second embodiment of the handling apparatus. In Fig. 5 the handling apparatus is attached to an FOUP from the rear. The handles 9 are in a first position immediately after the handling apparatus is attached to the FOUP (white handles 9). After the handling apparatus has been attached to the FOUP 1 the handles 9 are brought into a second position (shaded handles 9) so that they are nearer to the side walls 2 of the FOUP. The rotation of the handles 9 around the second axis is indicated by two arrows in Fig. 5. With this embodiment it is possible to leave the handling apparatus with the FOUP, since only very little extra space is needed when an FOUP is stored together with the handling apparatus as compared to the storage of only the FOUP.

As with the embodiment according to Fig. 4A and 4B also with the embodiment according to Fig. 5 each handle 9 may be coupled to the bar 7 with springs which define a normal position. This may be the position in which the handle is bent forward (shaded handles 9). The handle may also be lockable on the bar so that it can be fixed at any rotation angle around the second axis.

The material which is most suited for the handling apparatus - that is the grippers 11 and/or the handles 9 - is a stiff or hard plastic material. Instead of plastic material alternative materials such as rubber or metal may be used. However, in case of e.g. a metal frame it should be coated in order to prevent damages to the FOUP by the hard surface of the metal frame. The material for the coating of the frame is preferably a smooth layer such as rubber, soft plastic or cloth. As material for the metal frame aluminium is particularly preferable. And in general, all used materials for the handling apparatus according to the invention are to be clean room compatible.

As a summary: for manipulating a front opening unified pod 1 manually, the operator couples a handling apparatus according to the invention to the robotic flange 6 of the front opening unified pod, loads/unloads/moves the front opening unified pod into a desired position, and eventually decouples the handling apparatus from the front opening unified pod.

## Claims

1. Handling apparatus for manipulating a front opening unified pod (1) manually, the front opening unified pod comprising at least three side walls (2), a bottom wall (4), and a top wall (5), the top wall (5) being provided with a robotic flange (6) to which a robot arm is attachable,
the handling apparatus being **characterised by**
a bar (7) extending substantially along a first axis (8), with two handles (9) that swivel around said first axis (8) and lock on the bar in any position within a predetermined range; and
two grippers (11) extending substantially perpendicularly to said first axis (8) for being clamped onto said robotic flange (6).

2. Handling apparatus as claimed in claim 1, further **characterised in that** the length of the grippers (11) and/or the length of the handles (9) being such that the grippers can be attached to the front opening unified pod (1) from the front, from the side or from the rear of the front opening unified pod (1), respectively.

3. Handling apparatus as claimed in claim 1 or 2, further **characterised in that** each handle (9) and/or each gripper (11) is lockably coupled to the bar (7) so as to render each handle (9) and/or each gripper (11) swivelling around the first axis (8).

4. Handling apparatus as claimed in claim 3, further **characterised in that** each handle (9) and/or each gripper (11) swivels between two fixed positions.

5. Handling apparatus as claimed in claim 1 or 2, further **characterised in that** each handle (9) is lockably coupled to the bar (7) so as to render each handle (9) swivelling around a second axis perpendicular to the plane of said handle (9) and said bar (7).

6. Handling apparatus as claimed in claim 4, further **characterised in that** in one of the two fixed positions the handles (9) fold down flush with the side walls (2) of the front opening unified pod (1).

7. Handling apparatus as claimed in any of the preceding claims, **characterised in that** the handle (9) and/or the gripper (11) is made of rubber, hard plastic or metal.

8. Handling apparatus as claimed in claim 7, further **characterised in that** the handle (9) and/or the gripper (11) is covered by a smooth layer such as rubber, soft plastic or cloth.

9. A clean room comprising a handling apparatus according to any of the preceding claims.

10. A method of manipulating a front opening unified pod (1) manually, the front opening unified pod comprising of three side walls (2), a bottom wall (4), and a top wall (5), the top wall (5) being provided with a robotic flange (6) to which a robot arm is attachable,
comprising the steps of:
coupling a handling apparatus according to any of the claims 1 to 8 to the robotic flange (6) of the front opening unified pod,
manipulating the front opening unified pod by an operator so as to move it into a desired position, and
decoupling the handling apparatus from the front opening unified pod.

## Patentansprüche

1. Handhabungsvorrichtung zum manuellen Handhaben eines vereinheitlichten Behälters (1) mit Vorderöffnung, wobei der vereinheitlichte Behälter mit Vorderöffnung wenigstens drei Seitenwände (2), eine Bodenwand (4) und eine Deckenwand (5) umfasst, wobei die Deckenwand (5) mit einem Roboterflansch (6) ausgestattet ist, an den ein Roboterarm anschließbar ist,
wobei die Handhabungsvorrichtung **gekennzeichnet ist durch**
eine sich im Wesentlichen entlang einer ersten Achse (8) erstreckende Stange (7) mit zwei Griffen (9), die um die erste Achse (8) schwenken und auf der Stange in irgendeiner Stellung innerhalb eines vorbestimmten Bereichs verriegeln; und
zwei Greifer (11), die sich zum Klemmen an den Roboterflansch (6) im Wesentlichen senkrecht zu der ersten Achse (8) erstrecken.

2. Handhabungsvorrichtung nach Anspruch 1, weiterhin **dadurch gekennzeichnet, dass** die Länge der Greifer (11) und/oder die Länge der Griffe (9) derart sind, dass die Greifer an den vereinheitlichten Behälter (1) mit Vorderöffnung von der Vorderseite, von der Seite bzw. von der Rückseite des vereinheitlichten Behälters (1) mit Vorderöffnung angeschlossen werden können.

3. Handhabungsvorrichtung nach Anspruch 1 oder 2, weiterhin **dadurch gekennzeichnet, dass** jeder Griff (9) und/oder jeder Greifer (11) derart verriegelbar an die Stange (7) gekoppelt ist, dass jeder Griff (9) und/oder jeder Greifer (11) um die erste Achse (8) schwenkbar gemacht wird.

4. Handhabungsvorrichtung nach Anspruch 3, weiterhin **dadurch gekennzeichnet, dass** jeder Griff (9) und/oder jeder Greifer (11) zwischen zwei festen Stellungen schwenkt.

5. Handhabungsvorrichtung nach Anspruch 1 oder 2, weiterhin **dadurch gekennzeichnet, dass** jeder Griff (9) derart verriegelbar an die Stange (7) gekoppelt ist, dass jeder Griff (9) um eine senkrecht zu der Ebene des Griffs (9) und der Stange (7) verlaufende zweite Achse schwenkbar gemacht wird.

6. Handhabungsvorrichtung nach Anspruch 4, weiterhin **dadurch gekennzeichnet, dass** die Griffe (9) in einer der zwei festen Stellungen bündig mit den Seitenwänden (2) des vereinheitlichten Behälters (1) mit Vorderöffnung herunterklappen.

7. Handhabungsvorrichtung nach irgendeinem der vorherigen Ansprüche, **dadurch gekennzeichnet, dass** der Griff (9) und/oder der Greifer (11) aus Gummi, Hartplastik oder Metall gefertigt sind.

8. Handhabungsvorrichtung nach Anspruch 7, weiterhin **dadurch gekennzeichnet, dass** der Griff (9) und/oder der Greifer (11) mit einer weichen Schicht, wie Gummi, Weichplastik oder Gewebe, überzogen sind.

9. Reinraum, der eine Handhabungsvorrichtung nach irgendeinem der vorherigen Ansprüche umfasst.

10. Verfahren zum manuellen Handhaben eines vereinheitlichten Behälters (1) mit Vorderöffnung, wobei der vereinheitlichte Behälter mit Vorderöffnung drei Seitenwände (2), eine Bodenwand (4) und eine Deckenwand (5) umfasst, wobei die Deckenwand (5) mit einem Roboterflansch (6) ausgestattet ist, an den ein Roboterarm anschließbar ist,
das die folgenden Schritte umfasst:
Koppeln einer Handhabungsvorrichtung nach irgendeinem der Ansprüche 1 bis 8 an den Roboterflansch (6) des vereinheitlichten Behälters mit Vorderöffnung,
Handhaben des vereinheitlichten Behälters mit Vorderöffnung durch einen Bediener, um ihn in eine gewünschte Position zu bewegen, und
Abkoppeln der Handhabungsvorrichtung von dem vereinheitlichten Behälter mit Vorderöffnung.

## Revendications

1. Appareil de manipulation pour manipuler manuellement une nacelle unifiée à ouverture frontale (1), la nacelle unifiée à ouverture frontale comprenant au moins trois parois latérales (2), une paroi de fond (4), et une paroi de dessus (5), la paroi de dessus (5) étant pourvue d'une collerette de fixation pour robot (6) à laquelle peut être attaché un bras robotisé,
l'appareil de manipulation étant **caractérisé par** :
une barre (7) s'étendant essentiellement le long d'un premier axe (8), avec deux tringles (9) qui pivotent autour dudit premier axe (8) et qui se verrouillent sur la barre à une position quelconque dans une plage prédéterminée ; et
deux pinces (11) s'étendant dans une direction essentiellement perpendiculaire par rapport audit premier axe (8) pour être serrées sur ladite collerette de fixation pour robot (6).

2. Appareil de manipulation selon la revendication 1, **caractérisé, en outre, en ce que** la longueur des pinces (11) et/ou la longueur des tringles (9) sont telles que les pinces puissent être attachées à la nacelle unifiée à ouverture frontale (1) respectivement par l'avant, par le côté et par l'arrière de la nacelle unifiée à ouverture frontale (1).

3. Appareil de manipulation selon la revendication 1 ou 2, **caractérisé, en outre, en ce que** chaque tringle (9) et/ou chaque pince (11) peut être couplée d'une manière verrouillable à la barre (7), de façon à rendre chaque tringle (9) et/ou chaque poignée (11) pivotante autour du premier axe (8).

4. Appareil de manipulation selon la revendication 3, **caractérisé, en outre, en ce que** chaque tringle (9) et/ou chaque pince (11) pivote entre deux positions fixes.

5. Appareil de manipulation selon la revendication 1 ou 2, **caractérisé, en outre, en ce que** chaque tringle (9) peut être couplée d'une manière verrouillable à la barre (7), de façon à rendre chaque tringle (9) pivotante autour d'un deuxième axe, perpendiculaire au plan de ladite tringle (9) et de ladite barre (7).

6. Appareil de manipulation selon la revendication 4, **caractérisé, en outre, en ce que** dans l'une des deux positions fixes, les tringles (9) se replient jusqu'à entrer en affleurement avec les parois latérales (2) de la nacelle unifiée à ouverture frontale (1).

7. Appareil de manipulation selon l'une quelconque des revendications précédentes, **caractérisé en ce que** la tringle (9) et/ou la pince (11) est constituée de caoutchouc, de plastique dur ou de métal.

8. Appareil de manipulation selon la revendication 7, **caractérisé, en outre, en ce que** la tringle (9) et/ou la pince (11) est recouverte d'une couche lisse telle que du caoutchouc, un plastique souple ou une étoffe.

9. Salle blanche comprenant un appareil de manipulation selon l'une quelconque des revendications précédentes.

10. Procédé de manipulation manuelle d'une nacelle unifiée à ouverture frontale (1), la nacelle unifiée à ouverture frontale comprenant au moins trois parois latérales (2), une paroi de fond (4), et une paroi de dessus (5), la paroi de dessus (5) étant pourvue d'une collerette de fixation pour robot (6) à laquelle peut être attaché un bras robotisé,
comprenant les étapes qui consistent à :
coupler un appareil de manipulation selon l'une quelconque des revendications 1 à 8 à une collerette de fixation pour robot (6) de la nacelle unifiée à ouverture frontale,
manipuler la nacelle unifiée à ouverture frontale par un opérateur, de façon à la déplacer dans une position souhaitée, et
découpler l'appareil de manipulation de la nacelle unifiée à ouverture frontale.
